# FASCICULE DE BREVET EUROPEEN

(11) **EP 3 992 855 B1**
(45) Date de publication et mention de la délivrance du brevet: **06.03.2024**
(21) Numéro de dépôt: 21204354.1
(22) Date de dépôt: 23.10.2021
(51) Int. Cl.: G06K 19/07, G06K 19/077

(54) **PROCÉDÉ DE FABRICATION D'UN MODULE DE CARTE À PUCE AVEC COMPOSANT ÉLECTRONIQUE SOUDÉ**
VERFAHREN ZUR HERSTELLUNG EINES CHIPKARTEN-MODULS MIT EINER GESCHWEISSTEN ELEKTRONISCHEN KOMPONENTE
METHOD FOR MANUFACTURING A CHIP-CARD MODULE WITH WELDED ELECTRONIC COMPONENT

(30) Priorité: 30.10.2020 FR 2011177
(43) Date de publication de la demande: 04.05.2022
(73) Titulaire: Linxens Holding, 78200 Mantes-la-Jolie (FR)
(72) Inventeur: MATHIEU, Christophe, 78200 MANTES-LA-JOLIE (FR); GIMBERT, Guillaume, 43800 VOREY (FR)
(74) Mandataire: INNOV-GROUP

(56) Documents cités:
- CA-A1- 2 503 688
- US-A1- 2019 294 943
- US-A1- 2019 340 398

## Description

### Domaine technique

L'invention concerne le domaine de la carte à puce.

### Etat de la technique

Les cartes à puce sont généralement formées d'un corps de carte en matière plastique dans lequel est logé un module comprenant une puce, c'est-à-dire un circuit intégré, électriquement connectée à des contacts et/ou à une antenne pour une communication avec ou sans contact avec un lecteur de carte. Outre une antenne et un module comprenant une puce, d'autres éléments de circuiterie et/ou d'autres composants électroniques peuvent être intégrés dans le corps de carte. C'est le cas notamment lorsque des capteurs biométriques pour la lecture d'empreintes digitales sont utilisés pour renforcer la sécurité ou simplifier l'utilisation des cartes à puces.

Cependant, l'intégration de composants électroniques dans le corps d'une carte à puce peut poser des problèmes lors de la lamination des différentes couches constitutives du corps de carte. En effet, parmi les problèmes éventuellement rencontrés, il y a, par exemple, la détérioration des composants lors de la lamination, la surépaisseur inesthétique qui peut résulter de l'insertion du ou des composants entre les couches, l'imprécision après lamination du positionnement des zones de connexion destinées à la connexion des composants électroniques.

Une solution consiste à intégrer au moins certains composants au module comprenant déjà la puce ou destiné à recevoir la puce (On peut par exemple se référer aux documents US2019294943A1, CA2503688A1 et US2019340398A1 pour des exemples de cartes à puce avec plusieurs composants sur un module). En effet, ce module est logé dans une cavité généralement fraisée dans le corps de la carte, après lamination des couches constitutives de celle-ci. Ainsi, par exemple, les composants ne sont pas soumis à une opération de lamination.

L'invention se place dans cette perspective et vise à contribuer au moins partiellement à l'amélioration des procédés de fabrication des modules de carte à puce comprenant des composants en plus de la puce habituellement supportée par de tels modules.

### Résumé de l'invention

Ainsi il est proposé selon l'invention un procédé de fabrication d'un module de carte à puce, comprenant les opérations consistant
- à fournir un substrat diélectrique supportant une première couche de matériau électriquement conducteur sur une première face principale du substrat, et une deuxième couche de matériau électriquement conducteur sur une deuxième face principale du substrat, et
- à fixer un circuit intégré sur le substrat, du côté de sa première face principale, et à connecter ce circuit intégré à des premiers plots de connexion.

Ce procédé comprend en outre une ou plusieurs opérations au cours desquelles un matériau de soudure fusible est déposé sur des deuxièmes plots de connexion formés dans la première couche de matériau électriquement conducteur et au moins un composant électronique est connecté aux deuxièmes plots de connexion par refusion du matériau de soudure préalablement déposé sur les deuxièmes plots de connexion.

Ainsi, grâce à l'invention, il est possible d'utiliser des composants électroniques, possiblement sensibles à la lamination, dans la fabrication des modules de carte à puce. La connexion du circuit intégré peut se faire par une technologie de connexion par fils (« wire bonding » en anglais) ou par une technologie dite de la puce retournée (« flip-chip » en anglais). Lorsque la connexion de la puce est réalisée à l'aide d'une technologie dite de la puce retournée, la connexion peut être réalisée à l'aide d'une pâte conductrice ou même à l'aide d'un matériau de soudure fusible et d'une opération de refusion de celui-ci (éventuellement la même que celle permettant de connecter le ou les autres composants électroniques). Lorsque la connexion de la puce est réalisée à l'aide de fils, la combinaison des deux techniques de connexion que sont la connexion par fils et la soudure par refusion (« reflow soldering » en anglais) sur un même support va à l'encontre des préjugés de l'Homme du Métier pour qui une étape de refusion antérieure à la connexion par fils est susceptible de polluer les plots de connexion destinés à la connexion par fil, ou à l'inverse la température de refusion peut dégrader la puce si celle-ci a été connectée préalablement.

Ce procédé de fabrication d'un module de carte à puce comprend éventuellement l'une et/ou l'autre des caractéristiques suivantes, considérées chacune indépendamment l'une de l'autre, ou chacune en combinaison d'une ou plusieurs autres :
- il comprend une opération au cours de laquelle un masque de soudure est déposé sur la première face principale du substrat avant de procéder à la refusion du matériau de soudure ;
- l'opération de refusion du matériau de soudure est réalisée avant l'opération au cours de laquelle le circuit intégré est connecté aux premiers plots de connexion ; alternativement, l'opération de refusion du matériau de soudure est réalisée après l'opération au cours de laquelle le circuit intégré est connecté aux premiers plots de connexion ;
- le circuit intégré est connecté aux premiers plots de connexion, à l'aide de fils ;
- le matériau de soudure a une température de fusion comprise entre 130 et 250°C ;
- le matériau de soudure est déposé par une technique choisie dans la liste suivante : jet, dispense, transfert par pointe (« pin transfer » en anglais) et sérigraphie ;
- il comprend une opération de dépôt d'un matériau d'encapsulation sur le circuit intégré et les fils de connexion de ce circuit intégré aux premiers plots de connexion, sans recouvrir le composant électronique avec ce matériau d'encapsulation.

Selon encore un autre aspect, l'invention concerne un module de carte à puce comprenant un substrat diélectrique supportant une première couche de matériau électriquement conducteur sur une première face principale du substrat, une deuxième couche de matériau électriquement conducteur sur une deuxième face principale du substrat, un circuit intégré solidaire du substrat, du côté de sa première face principale, et connecté, éventuellement à l'aide de fils, à des premiers plots de connexion. Ce module comprend en outre au moins un composant électronique soudable connecté à des deuxièmes plots, formés dans la première couche de matériau électriquement conducteur, à l'aide d'un matériau de soudure fusible déposé et refondu sur les deuxièmes plots de connexion de soudure.

Ce module de carte à puce comprend éventuellement l'une et/ou l'autre des caractéristiques suivantes, considérées chacune indépendamment l'une de l'autre, ou chacune en combinaison d'une ou plusieurs autres :
- le composant électronique est un composant passif ;
- le matériau de soudure est un alliage qui peut être un alliage comprenant au moins deux des éléments de la liste suivante : bismuth, étain, argent et cuivre ;
- un matériau d'encapsulation englobe le circuit intégré, sans recouvrir le composant électronique.

Selon encore un autre aspect, l'invention concerne une carte à puce comprenant un corps de carte et une cavité dans laquelle est logé un module fabriqué selon un procédé conforme à l'invention.

### Brève description des figures

D'autres aspects, buts et avantages de l'invention apparaîtront à la lecture de la description détaillée qui suit, ainsi qu'à l'aide des dessins annexés, donnés à titre d'exemples non-limitatifs et sur lesquels :
[Fig.1] représente schématiquement en perspective un exemple de carte à puce ;
[Fig.2] représente schématiquement un exemple d'organisation de la circuiterie et des composants dans une carte à puce telle que celle illustrée par la figure 1 ;
[Fig.3] représente schématiquement en élévation une portion de circuit imprimé correspondant à un exemple de mode de réalisation d'un module selon l'invention, vu par sa face avant ;
[Fig.4] représente schématiquement en élévation une portion de circuit imprimé correspondant à l'exemple de mode de réalisation du module illustré par la figure 3, vu par sa face arrière ;
[Fig.5] représente schématiquement un détail de la figure 4 ;
[Fig.6] représente schématiquement différentes étapes d'un exemple de procédé de fabrication d'un module de carte à puce, selon l'invention.

### Description détaillée

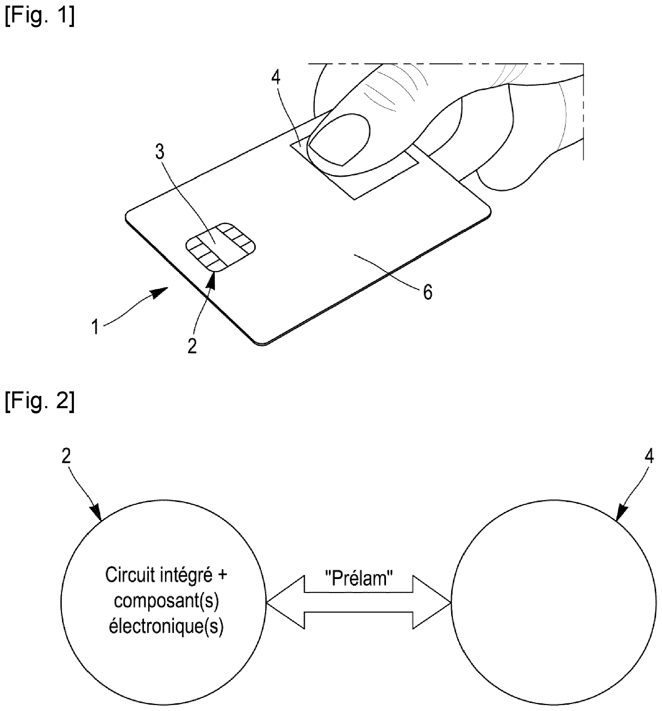

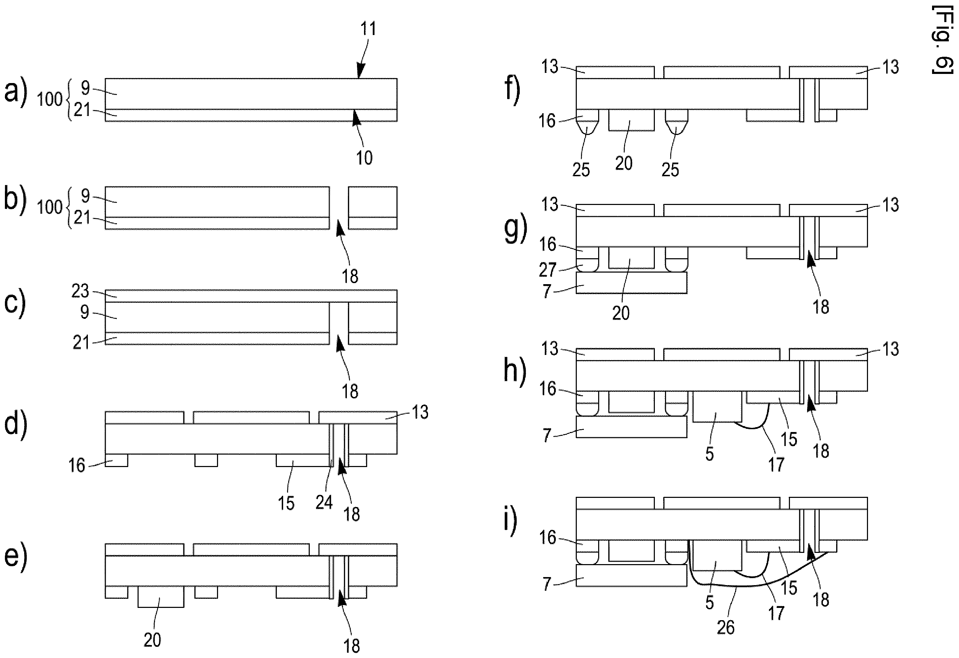

Un exemple de carte à puce 1 selon l'invention est représenté sur la figure 1. Selon cet exemple, la carte à puce 1 est une carte bancaire au format ID-1. Cette carte à puce 1 comporte un premier module 2 comprenant un connecteur 3 et un deuxième module 4. Le premier module 2 est par exemple un module de type bancaire (aussi appelé module « EMV » pour Europay Mastercard Visa) répondant à la norme ISO 7810. Le connecteur 3 permet de connecter électriquement une puce électronique 5 (voir figure 6) montée sur le premier module 2, à un lecteur de cartes, pour échanger des données entre la puce 5 et le lecteur de cartes.

Dans le cas d'une carte à puce 1 à double interface, c'est-à-dire permettant une lecture par contact ou sans contact, une antenne est intégrée dans le corps 6 de la carte à puce 1. Cette antenne est connectée par exemple à la puce située dans le premier module 2. Cette antenne permet d'échanger sans contact des données entre la puce 5 et un lecteur de cartes sans contact. Cette antenne, ou une autre partie d'un circuit électrique situé dans le corps de carte 6, peut être également connectée électriquement au deuxième module 4 intégré dans la carte à puce 1. Le deuxième module 4 est par exemple un module biométrique. Ce deuxième module 4 comprend alors par exemple un capteur biométrique pour la reconnaissance d'empreintes digitales. Le deuxième module 4 permet par exemple de déterminer si l'empreinte digitale lue par le capteur biométrique correspond à celle d'un utilisateur qui a l'autorisation de se servir de cette carte à puce 1. Dans ce cas, une communication sans contact entre la puce 5 et un lecteur peut être autorisée. D'autres composants (diode électroluminescente par exemple) sont éventuellement logés dans le corps de carte 6.

Comme illustré par la figure 2, la communication entre les premier 2 et deuxième 4 modules se fait à travers un circuit électrique réalisé sur un « prélam » (« inlay » en anglais) formé d'un support diélectrique. Ce circuit électrique peut être formé d'un fil ou plusieurs fils conducteurs incrustés dans le support diélectrique, ou bien de pistes conductrices gravées dans une couche de matériau conducteur laminé avec le support diélectrique, ou encore de pistes conductrices découpées dans une couche de matériau conducteur avant d'être laminées sur le support diélectrique. Le « prélam » et son circuit électrique sont ensuite laminés avec diverses couches (couche(s) de compensation, couche(s) de finition, couche(s) d'impression, etc.) de matériau plastique, pour former un corps de carte 6. De manière connue, des cavités sont réalisées par fraisage dans le corps de carte 6. Les premier 2 et deuxième 4 modules sont intégrés dans ces cavités au niveau desquelles ils sont connectés au circuit électrique précédemment intégré dans le corps de carte 6.

Un avantage de l'invention est de permettre de regrouper sur le premier module 2, un ou plusieurs composants électroniques 7 qu'il est préférable de ne pas disposer dans le corps de carte 6. Pour ce faire, le premier module 2 est fabriqué de manière spécifique.

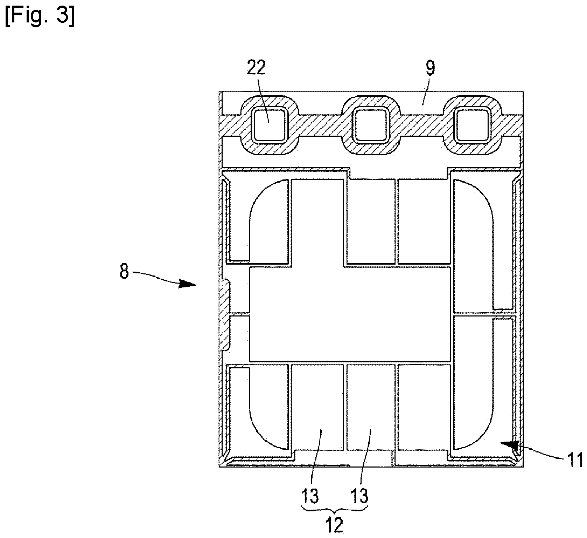

Les figures 3 à 5 montrent une portion de circuit imprimé 8. Cette portion correspond à la zone du circuit imprimé 8 destinée à réaliser un module, mais le circuit imprimé 8 comporte de nombreuses zones identiques ou semblables à celle montrée sur ces figures. Ces zones se répètent avec un pas donné sur la largeur d'une bande de circuit imprimé, et avec éventuellement un autre pas sur la longueur de cette bande de circuit imprimé. La bande est traitée en continu de rouleau à rouleau suivant un procédé dont un exemple est décrit ci-dessous.

Le premier module 2 comporte un substrat 9 ou support diélectrique. Ce substrat 9 diélectrique présente deux faces principales : une première face, dite « face arrière » ou « face de connexion » (« bonding side » en anglais) et une deuxième face 11, dite « face avant » ou « face contact ». Des plages conductrices 12 sont réalisées sur chacune des première 10 et deuxième 11 faces, selon un procédé décrit ci-dessous. Sur la deuxième face 11 (face avant), les plages conductrices 12 correspondent essentiellement à des contacts 13 destinés à établir une communication temporaire par contact avec un lecteur de carte. Sur la première face 10 (face arrière), les plages conductrices 12 correspondent à des pistes 14 et des plots de connexion 15, 16. Les plots de connexion 15, 16 servent à la connexion de la puce 5 et du ou des composants électroniques 7 fixés sur la première face 10. Des premiers plots de connexion 15 sont utilisés pour la connexion, à l'aide de fils de connexion 17 électriquement conducteurs (voir figure 6), de la puce 5 aux pistes conductrices 14. Des deuxièmes plots de connexion 16 sont utilisés pour la connexion par soudure du ou des composants électroniques 7 aux pistes conductrices 14. Par ailleurs, les pistes conductrices 14 relient électriquement les premiers 15 et deuxièmes 16 plots à des plages de connexion 19 destinées à connecter le premier module 2 au circuit électrique intégré dans le corps de carte 6, ou à des puits de connexion 18 permettant d'établir une connexion, à travers le substrat 9, avec les contacts 13.

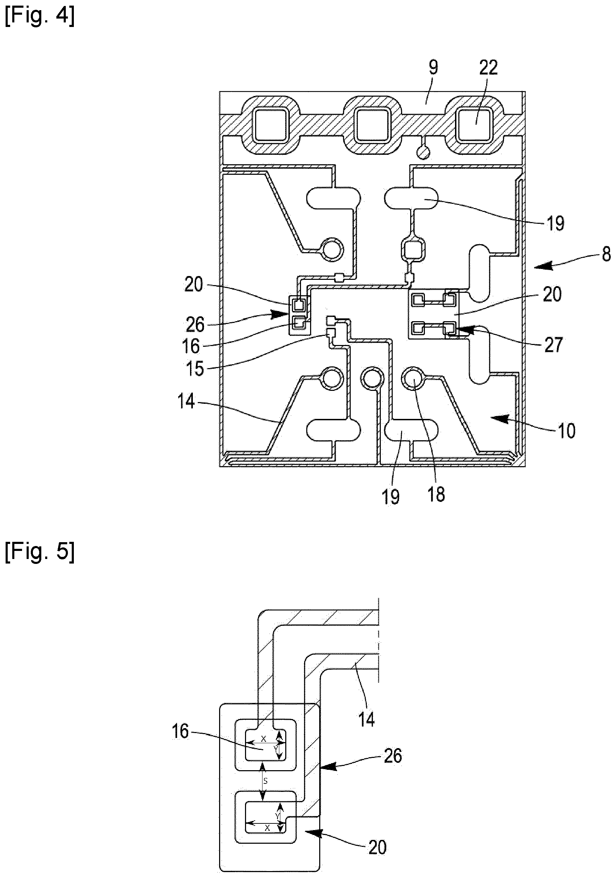

Comme illustré sur les figures 4 et 5, un masque de soudure 20 (« solderMask » en anglais) est disposé autour des deuxièmes plots de connexion 16. Le masque de soudure est déposé sur le substrat 9. Il recouvre partiellement des pistes conductrices 14 reliées aux deuxièmes plots de connexion 16, mais laisse les deuxièmes plots de connexion 16 découverts. Dans la configuration NSMD (pour « Non SolderMask Defined » en anglais), un espace dont la largeur est par exemple comprise entre 50 et 200 µm est ménagé, autour des deuxièmes plots de connexion 16, entre les deuxièmes plots de connexion 16 et le masque de soudure 20. Dans la configuration SMD (pour SolderMask Defined » en anglais), une zone de chevauchement dont la largeur est par exemple comprise entre 50 et 200 µm recouvre les deuxièmes plots de connexion 16.

Il est connu qu'au cours de la mise en oeuvre de procédés de montage en surface (« SMT » ou Surface Mount Technology en anglais), un effet indésirable peut se produire au cours de l'opération de refusion destinée à souder les bornes d'un composant sur des plots de circuits imprimés. Cet effet indésirable, connu sous le nom de « Tombstoning » ou « Manhattan Effect » ou encore « Chip lifting», provoque le redressement du composant par rapport au plan du circuit imprimé. Le composant redressé peut être connecté par soudure par l'une de ses bornes mais déconnecté (hors du matériau de soudure refondu) à l'autre. La figure 5 représente une portion de circuit imprimé, au niveau des deuxièmes plots de connexion 16. Ces plots de connexion 16 ont une longueur X, une largeur Y et sont espacés d'une distance S.

Les inventeurs ont constaté qu'avec une valeur de X égale à 400µm, une valeur égale à Y de 400µm et une distance S égale à 400µm, l'effet « Tombstone » se produit dans plus de 10% des cas, pour un composant de type 0201 (format codifié selon la norme internationale EIAJ : longueur et largeur en centième d'Inch, les 2 ou 3 premiers chiffres du code représentant la longueur et les 2 derniers chiffres représentant la largeur. Pour un composant 0201 les dimensions sont donc : Longueur du composant 0,6 ± 0,03mm, largeur du composant 0,3 ± 0,03mm et dimension de la borne à souder parallèlement à la longueur 0,15 ± 0,05mm). Par contre, les inventeurs ont également trouvé que si X est égal à 400 ± 50µm, Y est égal à 300 ± 50µm et S est égal à 300 ± 50µm, alors l'effet « Tombstone » ne se produit plus que dans moins de 1% des cas, pour un composant de type 0201. Ce sont donc les valeurs de X, Y et S mentionnées ci-dessus qui sont avantageusement adoptées dans l'exemple de mode de réalisation décrit dans ce document. Plus généralement, l'effet « Tombstone » est réduit si la distance S entre les plots de connexion 16 est inférieure, égale ou proche de celle correspondant à la longueur du composant diminuée de deux fois la dimension de la borne à souder parallèle à la longueur. En d'autres termes, le composant électronique 7 présente deux extrémités longitudinales et une borne à souder à chaque extrémité longitudinale, et la distance entre les bornes est supérieure, égale ou proche de la distance S entre les plots de connexion respectifs 16. Des dimensions plus générales de composants sont indiquées ci-dessous. Les valeurs de X, Y et S pourront être éventuellement adaptées, sachant que, d'une part, si la distance S diminue, le composant repose davantage sur la soudure refondue et, d'autre part, si la surface des plots de connexion 16 est réduite, les forces tendant à faire se redresser le composant sont moindres. L'un et ou l'autre de ces deux effets permettent de limiter la fréquence d'apparition de l'effet « Tombstone ».

Un exemple de procédé de fabrication d'un exemple de mode de réalisation d'un premier module 2 est décrit ci-dessous en relation avec la figure 6.

Ce procédé comprend la fourniture d'un matériau complexe 100 comprenant un substrat 9 en matériau diélectrique sur lequel est laminé une première couche 21 ou feuillet constitué d'un premier matériau électriquement conducteur (voir figure 6a). Par exemple le matériau diélectrique du substrat 9 est un polyimide ou un verre-époxy dont l'épaisseur est comprise entre 25 et 100 micromètres, et est préférentiellement égale à 100 micromètres et la première couche 21 de matériau électriquement conducteur est constitué de cuivre ou d'un alliage de cuivre dont l'épaisseur est comprise entre 12 et 70 micromètres, et est préférentiellement égale à 35 micromètres.

Pour une mise en oeuvre du procédé selon l'invention performante au plan industriel, ce matériau complexe 100 est avantageusement fourni en rouleau et le procédé est mis en oeuvre en continu de rouleau à rouleau (« reel-to-reel » en anglais). Le matériau complexe 100 peut être fourni sous forme d'un stratifié (« clad » en anglais ; par exemple un stratifié cuivré ou « copper clad » en anglais). Alternativement, il peut être fourni sous la forme d'un complexe multicouche (non-représenté) comprenant un substrat 9 de matériau diélectrique, une première couche 21 de matériau électriquement conducteur, et une couche de matériau adhésif (par exemple de type epoxy) entre le substrat de matériau diélectrique et la première couche de matériau électriquement conducteur. Le matériau adhésif a par exemple une épaisseur comprise entre 10 et 25 micromètres. Ce complexe 100 multicouche subit une lamination. Le matériau adhésif subit éventuellement une opération de séchage en continu pour évacuer les solvants présents dans la formulation au moment de son dépôt. La couche de matériau adhésif permet ainsi de fixer la première couche de matériau électriquement conducteur sur la première face 10 du substrat 9 de matériau diélectrique. La lamination peut éventuellement être suivie d'une opération de réticulation thermique du matériau adhésif. L'utilisation d'un matériau complexe stratifié (sans couche de colle entre la première face 10 principale du substrat et la première couche 21 de matériau électriquement conducteur) est préférable car elle peut permettre d'éviter des problèmes de fluage de la colle lors de l'opération de refusion décrite ci-dessous et car elle peut permettre d'éviter les problèmes d'adhérence des fils de connexion 17 lors de l'opération de connexion de la puce 5 à des plots de connexion.

Avantageusement, le procédé comporte également une opération non-représentée au cours de laquelle une couche de matériau adhésif (différente de celle éventuellement déjà déposée comme expliqué ci-dessus) est déposée, par exemple sur une épaisseur comprise entre 10 et 25 micromètres, sur la deuxième face 11 principale du substrat 9. Cette couche de matériau adhésif (par exemple de type epoxy) subit aussi éventuellement une opération de séchage en continu pour évacuer les solvants présents dans la formulation au moment de son dépôt.

Le matériau complexe 100 comprend donc avantageusement un substrat 9 diélectrique supportant une première couche 21 de matériau électriquement conducteur sur sa première face 10 principale et une couche de matériau adhésif sur sa deuxième face 11 principale. Le matériau complexe 100 ainsi constitué subit ensuite une opération de perforation (avantageusement mécanique, mais qui peut éventuellement être réalisée par découpe laser) pour former des puits de connexion18 (voir figure 6b) et des trous d'entrainement 22 (voir figures 3 et 4). Les puits de connexion 18 et les trous d'entrainement 22 traversent totalement l'ensemble du matériau complexe 100 (substrat 9, première couche 21 de matériau électriquement conducteur, éventuelle couche de matériau adhésif entre le substrat et la première couche 21 de matériau conducteur, ainsi qu'une autre couche de matériau adhésif).

Le matériau complexe 100 ainsi perforé subit une opération de lamination avec une deuxième couche 23 de matériau électriquement conducteur. Cette deuxième couche 23 de matériau conducteur obture au moins certains des puits de connexion 18 pour former des trous borgnes (voir figure 6c).

Suivent ensuite des opérations de photolithogravure permettant de réaliser des plots de connexion 15, 16 et des pistes de connexion 14 sur la première face 10 principale, ainsi que des contacts 13 sur la deuxième face 11 principale. Ces étapes comprennent par exemple des opérations de lamination d'un film sec de résine photosensible sur les première 21 et deuxième 23 couches de matériau conducteur recouvrant les première 10 et deuxième 11 faces principales du substrat 9, des opérations d'insolation de ces films de résine photosensible à travers des masques, la révélation de la résine photosensible et la gravure sur certaines zones des première 21 et deuxième 23 couches de matériau conducteur, pour former des plots de connexion 15, 16, des pistes de connexion 14 ou tout autre motif.

Alternativement, des plots de connexion 15, 16 et des pistes de connexion 14 sont réalisés par découpe ou gravure dans la première couche 21 de matériau électriquement conducteur (selon la technologie dite « leadframe » en anglais), avant de les laminer sur la première face 10 principale du substrat diélectrique 9.

Des opérations de dépôts électrolytiques de couches de métaux 24 (cuivre, nickel, or, palladium, argent et leurs alliages par exemple) sont avantageusement réalisées sur l'une et/ou l'autre des première 10 et deuxième 11 faces principales du substrat 9. Ces dépôts sont par exemple destinés à faciliter la soudure de fils de connexion 17 sur les plots de connexion 15, 16.

Un masque de soudure 20 est ensuite déposé autour des deuxièmes plots de connexion 16 destinés à recevoir un matériau de soudure 25 (voir figures 6e et 6f). Avantageusement, le masque de soudure 20 est constitué d'un matériau de type époxy photo-imageable. Ceci permet de réaliser plus précisément, en continu notamment, les motifs entourant les deuxièmes plots de connexion 16. Le masque de soudure 20 a une épaisseur comprise entre 13 micromètres et 58 micromètres, est préférentiellement égale à 38 micromètres.

Suit une opération de dépôt d'un matériau de soudure 25 sur les deuxièmes plots de connexion 16 entourés du masque de soudure 20 et destinés à être connectés à un composant électronique 7 (voir figures 6f et 6g). Par exemple, le matériau de soudure 25 est constitué d'un alliage d'étain (96,5%), d'argent (3%) et de cuivre (0,5%) connu sous la dénomination « SAC 305 », et dont la température de fusion est environ de 220°C. Cette opération de dépôt d'un matériau de soudure 25 est réalisée par exemple par dispense ou par jet (« jetting » en anglais) ou par sérigraphie (« screen-printing » en anglais) ou par transfert par pointe (« pin transfer » en anglais). Le dépôt par jet ou par dispense est avantageux lorsque le composant électronique 7 est de petite taille car la taille de la goutte du matériau de soudure 25 doit être suffisamment petite pour que la pose du composant soit rendue possible et fiable. Par exemple, pour la pose de composants au format codifié 0201 ou 01005, il est souhaitable que le diamètre des gouttes du matériau de soudure 25 ne dépasse pas 200 micromètres, ce qui est réalisable plus facilement avec le dépôt par jet ou par dispense que par sérigraphie.

Un ou plusieurs composants électroniques 7 sont ensuite déposés sur les deuxièmes plots de connexion 16 sur lesquels a été préalablement déposée une goutte de matériau de soudure 25 (voir figure 6g). Le ou les composants électroniques 7 sont par exemple des composants passifs. Plus particulièrement, il peut s'agir de condensateurs ou capacités permettant d'adapter la capacitance du circuit de l'antenne présente dans le corps de carte 6 et connectée au premier module 2. Par exemple, de tels composants électroniques 7 ont une forme générale parallélépipédique avec une longueur totale comprise entre 0,4 et 1,0 mm, une largeur comprise entre 0,2 et 0,5 mm et une hauteur comprise entre 0,2 et 0,5 mm. A chaque extrémité longitudinale de ces parallélépipèdes sont formés des bornes électriquement conductrices s'étendant sur toute la largeur et toute la hauteur des composants électroniques 7 et sur une portion de la dimension correspondant à la longueur de ces composants électroniques 7. Ces composants électroniques 7 sont mis en place sur les deuxièmes plots de connexion 16 à l'aide d'une technique de report de puce par transfert (« pick and place » en anglais). La mise en oeuvre de ces composants électroniques 7 soudables est généralement moins onéreuse que celle des composants électroniques 7 à connecter à l'aide de fils. Sur la figure 4, deux zones 26, 27 de plots de connexion 15 sont représentées. Sur une première zone 26, deux plots de connexion 15 sont réalisés pour connecter entre eux un composant électronique 7. Sur une deuxième zone 27, quatre plots de connexion 15 sont réalisés pour connecter deux composants électroniques 7. Ainsi, il est possible de connecter un nombre variable de composants électroniques 7 en fonction des besoins.

Puis le circuit préalablement obtenu est soumis à une refusion selon un profil de température présentant un pic à 250°C, afin de réaliser une opération de refusion des gouttes du matériau de soudure 25 déposé sur les deuxièmes plots de connexion 16. Le masque de soudure 20 permet de contrôler l'étalement et la hauteur des gouttes du matériau de soudure 25 lors de l'opération de refusion.

Une puce 5 est ensuite déposée sur la première face du substrat et est connectée aux deuxièmes plots de connexion 16 à l'aide de fils 17 électriquement conducteurs. Cette connexion est réalisée par ultrasons.

Un matériau d'encapsulation 26 (une résine) est ensuite déposé sur la puce 5 et les fils 17 afin de les protéger. Pour de ne pas ajouter une épaisseur trop importante au premier module 2, le matériau d'encapsulation 26 peut ne pas être déposé sur les composants électroniques 7. Alternativement, le matériau d'encapsulation 26 est déposé aussi sur un ou des composants électroniques 7. Si nécessaire, la cavité dans laquelle doit être logé le premier module 2, est fraisée avec plus de profondeur dans le corps de carte 6.

Toutes les opérations décrites ci-dessus sont avantageusement mise en oeuvre en continu de bobine à bobine.

Il a été décrit ci-dessus des opérations de mise en place et de connexion de la puce 5 postérieures à celles de mise en place et de connexion des composants électroniques 7. Selon une variante, l'ordre de ces opérations est inversé.

Il a été décrit ci-dessus un procédé comprenant la fourniture d'un matériau complexe 100 comprenant un substrat 9 en matériau diélectrique sur lequel est laminé une première couche 21 ou feuillet constitué d'un premier matériau électriquement conducteur, puis auquel est ajoutée une deuxième couche 23 de matériau électriquement conducteur, après perforation des puits de connexion18. Alternativement, le procédé comprend la fourniture d'un matériau complexe (non-illustré) comprenant un substrat ou support diélectrique sur chacune des faces duquel sont laminées les première et deuxième couches de matériau électriquement conducteur. Les puits de connexion sont alors formés à l'aide d'un faisceau laser, à travers la première couche de matériau électriquement conducteur et le substrat.

## Revendications

1. Procédé de fabrication d'un module (2) de carte à puce (1), comprenant les opérations consistant
à fournir un substrat (9) diélectrique supportant une première couche (21) de matériau électriquement conducteur sur une première face (10) principale du substrat (9), et une deuxième couche (23) de matériau électriquement conducteur sur une deuxième face (11) principale du substrat (9),
à fixer au moins un circuit intégré (5) sur le substrat (9), du côté de sa première face (10) principale, et à connecter ledit au moins un circuit intégré (5) à des premiers plots de connexion (15),
**caractérisé par le fait qu'**il comprend en outre une ou plusieurs opérations au cours desquelles un matériau de soudure (25) fusible est déposé sur des deuxièmes plots de connexion (16) formés dans la première couche (21) de matériau électriquement conducteur et au moins un composant électronique (7) est connecté aux deuxièmes plots de connexion (16) par refusion du matériau de soudure (25).

2. Procédé selon la revendication 1, comprenant une opération au cours de laquelle un masque de soudure (20) est déposé sur la première face (10) principale du substrat (9) avant de procéder à la refusion du matériau de soudure (25).

3. Procédé selon la revendication 1 ou 2, dans lequel l'opération de refusion du matériau de soudure (25) est réalisée avant l'opération au cours de laquelle le circuit intégré (5) est connecté aux premiers plots de connexion (15).

4. Procédé selon la revendication 1 ou 2, dans lequel l'opération de refusion du matériau de soudure (25) est réalisée après l'opération au cours de laquelle le circuit intégré (5) est connecté aux premiers plots de connexion (15).

5. Procédé selon l'une des revendications précédentes, dans lequel le circuit intégré (5) est connecté aux premiers plots de connexion, à l'aide de fils (17).

6. Procédé selon l'une des revendications précédentes, dans lequel le matériau de soudure (25) a une température de fusion comprise entre 130 et 250°C

7. Procédé selon l'une des revendications précédentes, dans lequel le matériau de soudure (25) est déposé par une technique choisie dans la liste suivante : jet, dispense, transfert par pointe et sérigraphie.

8. Procédé selon l'une des revendications précédentes, comprenant une opération de dépôt d'un matériau d'encapsulation (26) sur le circuit intégré (5), sans recouvrir le composant électronique (7) avec ce matériau d'encapsulation (26).

9. Procédé selon l'une des revendications précédentes, dans lequel les deuxièmes plots de connexion (16) ont une longueur (X) égale à 400 ± 50µm, une largeur (Y) égale à 300 ± 50µm et dans lequel la distance (S) entre les deuxièmes plots de connexion (16) est égale à 300 ± 50µm.

10. Module de carte à puce comprenant un substrat (9) diélectrique supportant une première couche (21) de matériau électriquement conducteur sur une première face (10) principale du substrat (9), une deuxième couche (23) de matériau électriquement conducteur sur une deuxième face (11) principale du substrat, un circuit intégré (5) solidaire du substrat (9), du côté de sa première face (10) principale, et connecté à des premiers plots de connexion (15), **caractérisé par le fait qu'**il comprend en outre au moins un composant électronique (7) soudable connecté à des deuxièmes plots de connexion (16), formés dans la première couche (21) de matériau électriquement conducteur, à l'aide d'un matériau de soudure (25) fusible déposé et refondu sur les deuxièmes plots de connexion (16).

11. Module de carte à puce selon la revendication 10, dans lequel le composant électronique (7) est un composant passif.

12. Module de carte à puce selon l'une des revendications 10 et 11, dans lequel le matériau de soudure (25) est un alliage comprenant au moins deux des éléments de la liste suivante : bismuth, étain, argent et cuivre.

13. Module de carte à puce selon l'une des revendications 10 à 12, dans lequel un matériau d'encapsulation (26) englobe le circuit intégré (5), sans recouvrir le composant électronique (7).

14. Module de carte à puce selon l'une des revendications 10 à 13, dans lequel le composant électronique (7) présente deux extrémités longitudinales et une borne à souder à chaque extrémité longitudinale, la distance entre les bornes étant supérieure ou égale à la distance (S) entre les plots de connexion respectifs (16).

15. Module de carte à puce selon la revendication 14, dans lequel les deuxièmes plots de connexion (16) ont une longueur (X) égale à 400 ± 50µm, une largeur (Y) égale à 300 ± 50µm et dans lequel la distance (S) entre les deuxièmes plots de connexion (16) est égale à 300 ± 50µm.

16. Carte à puce comprenant un corps de carte (6) et une cavité dans laquelle est logé un module selon l'une des revendications 10 à 14.

## Patentansprüche

1. Verfahren zur Herstellung eines Moduls (2) einer Chipkarte (1), das die Arbeitsgänge enthält, die darin bestehen
ein dielektrisches Substrat (9) bereitzustellen, das eine erste Schicht (21) aus elektrisch leitendem Material auf einer ersten Hauptseite (10) des Substrats (9) und eine zweite Schicht (23) aus elektrisch leitendem Material auf einer zweiten Hauptseite (11) des Substrats (9) trägt,
mindestens eine integrierte Schaltung (5) auf dem Substrat (9) auf der Seite seiner ersten Hauptseite (10) zu befestigen, und die mindestens eine integrierte Schaltung (5) an erste Anschlussklötzchen (15) anzuschließen,
**dadurch gekennzeichnet, dass** es außerdem einen oder mehrere Arbeitsgänge enthält, während denen ein schmelzbares Schweißmaterial (25) auf zweite Anschlussklötzchen (16) aufgebracht wird, die in der ersten Schicht (21) aus elektrisch leitendem Material geformt sind, und mindestens ein elektronisches Bauteil (7) durch Umschmelzen des Schweißmaterials (25) an die zweiten Anschlussklötzchen (16) angeschlossen wird.

2. Verfahren nach Anspruch 1, das einen Arbeitsgang enthält, während dessen eine Schweißmaske (20) auf die erste Hauptseite (10) des Substrats (9) aufgebracht wird, ehe das Umschmelzen des Schweißmaterials (25) durchgeführt wird.

3. Verfahren nach Anspruch 1 oder 2, wobei der Arbeitsgang des Umschmelzens des Schweißmaterials (25) vor dem Arbeitsgang durchgeführt wird, während dessen die integrierte Schaltung (5) an die ersten Anschlussklötzchen (15) angeschlossen wird.

4. Verfahren nach Anspruch 1 oder 2, wobei der Arbeitsgang des Umschmelzens des Schweißmaterials (25) nach dem Arbeitsgang durchgeführt wird, während dessen die integrierte Schaltung (5) an die ersten Anschlussklötzchen (15) angeschlossen wird.

5. Verfahren nach einem der vorhergehenden Ansprüche, wobei die integrierte Schaltung (5) mit Hilfe von Drähten (17) an die ersten Anschlussklötzchen angeschlossen wird.

6. Verfahren nach einem der vorhergehenden Ansprüche, wobei das Schweißmaterial (25) eine Schmelztemperatur zwischen 130 und 250°C hat.

7. Verfahren nach einem der vorhergehenden Ansprüche, wobei das Schweißmaterial (25) durch eine Technik aufgebracht wird, die aus der folgenden Liste ausgewählt wird: Jetten, Dispensen, Pin-Transfer und Siebdruck.

8. Verfahren nach einem der vorhergehenden Ansprüche, das einen Arbeitsgang des Aufbringens eines Verkapselungsmaterials (26) auf die integrierte Schaltung (5) enthält, ohne das elektronische Bauteil (7) mit diesem Verkapselungsmaterial (26) zu bedecken.

9. Verfahren nach einem der vorhergehenden Ansprüche, wobei die zweiten Anschlussklötzchen (16) eine Länge (X) gleich 400 ± 50µm, eine Breite (Y) gleich 300 ± 50µm haben, und wobei der Abstand (S) zwischen den zweiten Anschlussklötzchen (16) gleich 300 ± 50µm ist.

10. Chipkartenmodul, das ein dielektrisches Substrat (9) enthält, das eine erste Schicht (21) aus elektrisch leitendem Material auf einer ersten Hauptseite (10) des Substrats (9), eine zweite Schicht (23) aus elektrisch leitendem Material auf einer zweiten Hauptseite (11) des Substrats, eine mit dem Substrat (9) auf der Seite seiner ersten Hauptseite (10) fest verbundene und an erste Anschlussklötzchen (15) angeschlossene integrierte Schaltung (5) trägt, **dadurch gekennzeichnet, dass** es außerdem mindestens ein schweißbares elektronisches Bauteil (7) enthält, das an zweite Anschlussklötzchen (16) angeschlossen ist, die in der ersten Schicht (21) von elektrisch leitendem Material geformt sind, mit Hilfe eines schmelzbaren Schweißmaterials (25), das auf die zweiten Anschlussklötzchen (16) aufgebracht und umgeschmolzen wird.

11. Chipkartenmodul nach Anspruch 10, wobei das elektronische Bauteil (7) ein passives Bauteil ist.

12. Chipkartenmodul nach einem der Ansprüche 10 und 11, wobei das Schweißmaterial (25) eine Legierung ist, die mindestens zwei der Elemente der folgenden Liste enthält: Wismut, Zinn, Silber und Kupfer.

13. Chipkartenmodul nach einem der Ansprüche 10 bis 12, wobei ein Verkapselungsmaterial (26) die integrierte Schaltung (5) einschließt, ohne das elektronische Bauteil (7) zu bedecken.

14. Chipkartenmodul nach einem der Ansprüche 10 bis 13, wobei das elektronische Bauteil (7) zwei Längsenden und einen zu schweißenden Anschluss an jedem Längsende aufweist, wobei der Abstand zwischen den Anschlüssen größer als der oder gleich dem Abstand (S) zwischen den Anschlussklötzchen (16) ist.

15. Chipkartenmodul nach Anspruch 14, wobei die zweiten Anschlussklötzchen (16) eine Länge (X) gleich 400 ± 50µm, eine Breite (Y) gleich 300 ± 50µm haben, und wobei der Abstand (S) zwischen den zweiten Anschlussklötzchen (16) gleich 300 ± 50µm ist.

16. Chipkarte, die einen Kartenkörper (6) und einen Hohlraum enthält, in dem ein Modul nach einem der Ansprüche 10 bis 14 untergebracht ist.

## Claims

1. Process for manufacturing a chip-card (1) module (2), comprising the operations of providing a dielectric substrate (9) supporting a first layer (21) of electrically conductive material on a first main face (10) of the substrate (9), and a second layer (23) of electrically conductive material on a second main face (11) of the substrate (9),
fixing at least one integrated circuit (5) on the substrate (9), on the side of the first main face (10) thereof, and connecting said at least one integrated circuit (5) to first connection pads (15),
**characterized in that** it furthermore comprises one or more operations during which a meltable solder material (25) is deposited on second connection pads (16) formed in the first layer (21) of electrically conductive material and at least one electronic component (7) is connected to the second connection pads (16) by re-melting the solder material (25).

2. Process according to Claim 1, comprising an operation during which a solder mask (20) is deposited on the first main face (10) of the substrate (9) before remelting the solder material (25).

3. Process according to Claim 1 or 2, wherein the operation of remelting the solder material (25) is carried out before the operation during which the integrated circuit (5) is connected to the first connection pads (15).

4. Process according to Claim 1 or 2, wherein the operation of remelting the solder material (25) is carried out after the operation during which the integrated circuit (5) is connected to the first connection pads (15).

5. Process according to one of the preceding claims, wherein the integrated circuit (5) is connected to the first connection pads using wires (17).

6. Process according to one of the preceding claims, wherein the solder material (25) has a melting temperature of between 130 and 250°C.

7. Process according to one of the preceding claims, wherein the solder material (25) is deposited using a technique chosen from the following list: jetting, contact dispensing, pin transfer and screen-printing.

8. Process according to one of the preceding claims, comprising an operation of depositing an encapsulating material (26) on the integrated circuit (5), without covering the electronic component (7) with this encapsulating material (26).

9. Process according to one of the preceding claims, wherein the second connection pads (16) have a length (X) equal to 400 ± 50 µm, a width (Y) equal to 300 ± 50 µm, and wherein the distance (S) between the second connection pads (16) is equal to 300 ± 50 µm.

10. Chip-card module comprising a dielectric substrate (9) supporting a first layer (21) of electrically conductive material on a first main face (10) of the substrate (9), a second layer (23) of electrically conductive material on a second main face (11) of the substrate, an integrated circuit (5) joined to the substrate (9), on the side of the first main face (10) thereof, and connected to first connection pads (15), **characterized in that** it furthermore comprises at least one solderable electronic component (7) connected to second connection pads (16), which are formed in the first layer (21) of electrically conductive material, using a meltable solder material (25) that is deposited and re-melted on the second connection pads (16).

11. Chip-card module according to Claim 10, wherein the electronic component (7) is a passive component.

12. Chip-card module according to either of Claims 10 and 11, wherein the solder material (25) is an alloy comprising at least two of the elements from the following list: bismuth, tin, silver and copper.

13. Chip-card module according to one of Claims 10 to 12, wherein an encapsulating material (26) covers the integrated circuit (5), without covering the electronic component (7).

14. Chip-card module according to one of Claims 10 to 13, wherein the electronic component (7) has two longitudinal ends and one terminal to be soldered to each longitudinal end, the distance between the terminals being greater than or equal to the distance (S) between the respective connection pads (16).

15. Chip-card module according to Claim 14, wherein the second connection pads (16) have a length (X) equal to 400 ± 50 µm, a width (Y) equal to 300 ± 50 µm, and wherein the distance (S) between the second connection pads (16) is equal to 300 ± 50 µm.

16. Chip card comprising a card body (6) and a cavity in which a module according to one of Claims 10 to 14 is housed.
